Europäisches Patentamt

European Patent Office

Office européen des brevets

(19)

(11) Veröffentlichungsnummer: **0 061 063 B1**

(12) **EUROPÄISCHE PATENTSCHRIFT**

(45) Veröffentlichungstag der Patentschrift:
**10.12.86**

(21) Anmeldenummer: **82101846.2**

(22) Anmeldetag: **09.03.82**

(51) Int. Cl.⁴: **H 01 L 29/06, H 01 L 29/72**

(54) **Halbleiterbauelement hoher Sperrfähigkeit.**

(30) Priorität: **14.03.81 DE 3110000**

(43) Veröffentlichungstag der Anmeldung:
**29.09.82 Patentblatt 82/39**

(45) Bekanntmachung des Hinweises auf die Patenterteilung:
**10.12.86 Patentblatt 86/50**

(84) Benannte Vertragsstaaten:
**AT CH FR GB IT LI**

(56) Entgegenhaltungen:
**GB - A - 2 033 657**
**US - A - 3 891 479**
**US - A - 4 225 874**

**JAPANESE JOURNAL OF APPLIED PHYSICS,
supplement vol. 43, 1974, Tokio T. MATSUSHITA et al.
"Ultra-high voltage semiconductor devices"**

(73) Patentinhaber: **SEMIKRON Elektronik GmbH,
Sigmundstrasse 200, D-8500 Nürnberg 82 (DE)**

(72) Erfinder: **Chadda, Mohan, An der Breiting,
D-8500 Nürnberg (DE)**
Erfinder: **Irons, Robert, 2 Blenheim Ct. Shakespeare Rd.,
Wootton Bassett Swindon SN4 8HQ (GB)**

## Beschreibung

Die Erfindung betrifft ein Halbleiterbauelement hoher Sperrfähigkeit, dessen Halbleiterkörper eine hochohmige Mittelzone des einen Leitungstyps, an seiner einen Hauptfläche eine an die Mittelzone angrenzende, höher dotierte durchgehende Kontaktzone gleichen Leitungstyps und an seiner anderen Hauptfläche eine höher dotierte Planarzone sowie wenigstens eine, diese im Abstand umschliessende Feldbegrenzungszone, jeweils vom anderen Leitungstyp, aufweist, und mit entsprechenden Kontaktelektroden versehen ist.

Bei Halbleiterbauelementen hoher Sperrfähigkeit kann entsprechend der Anordnung der dotierten Zonen und der Ausbildung des Randbereichs des Halbleiterkörpers am Austritt des oder der pn-Übergänge zwischen Planarstrukturen, Mesastrukturen und Kegelstumpfstrukturen unterschieden werden. In der angegebenen Reihenfolge ist die Sperrspannungsbelastbarkeit immer höher, aber auch der Verfahrensaufwand zur Herstellung solcher Bauelemente immer grösser.

Die Planartechnik erlaubt die Herstellung dotierter Zonen von einer Seite aus, und die pn-Übergänge verlaufen an die Oberfläche(n) dieser Seite. Die Passivierung einer solchen Struktur erfolgt durch eine Oxidschicht an der Oberfläche im Bereich des Austritts der pn-Übergänge. Die Sperrfähigkeit von Planarstrukturen kann durch Anordnung einer Feldbegrenzungszone erhöht werden, welche die den hochsperrenden pn-Übergang bildende, hochdotierte Planarzone im Abstand umschliesst und dadurch die Raumladungsschicht im Bereich des Austritts des pn-Übergangs erweitert.

Für viele Anwendungsfälle reicht eine solche Feldbegrenzungszone nicht aus. Mehrere solcher Zonen reduzieren jedoch die aktive Fläche des Halbleiterkörpers erheblich und erhöhen den Aufwand an Ausgangsmaterial. Weiter ist die Passivierung von Planarstrukturen durch Oxidschichten unzureichend, weil solche Schichten nicht die genügende Dicke aufweisen. Darüberhinaus zeigen solche Oxidschichten schädliche Einschlüsse, welche die Stabilisierungswirkung nachteilig beeinflussen. Schliesslich verschlechtert sich die Oxidqualität, wenn durch mehrfaches Oxidieren eine grössere Schichtdicke erreicht werden soll.

Bei Mesastrukturen werden durch Tiefenätzung tafelförmige Abschnitte hergestellt, wodurch der pn-Übergang nicht an einer Hauptfläche, sondern an einer durch Ätzen erzielten Seitenfläche austritt. Eine solche Grabenätzung ist mit hohem Ätzaufwand und wegen des sogenannten Unterätzens auch mit hohem Aufwand an Ausgangsmaterial verbunden. Durch ein solches Unterätzen entstehen ferner abgeschrägte Ätzflächen mit sogenanntem negativen Winkel, und die gewünschte Sperrfähigkeit ist nur bei der Herstellung von sehr flachen Winkeln gegeben. Damit ist aber ein beträchtlicher Verlust an aktiver Fläche verbunden.

Der Erfindung liegt die Aufgabe zugrunde, hochsperrende Leistungshalbleiterbauelemente anzugeben, die unter Wahrung der Vorteile der Planartechnik eine gegenüber bekannten Planarbauelementen erheblich höhere Sperrfähigkeit aufweisen.

Die Lösung der Aufgabe besteht in den kennzeichnenden Merkmalen des Anspruchs 1.

Die Dicke des der Planarzone gegenüberliegenden Bereichs der Kontaktzone soll wenigstens das Dreifache der Dicke des übrigen Bereichs betragen.

Die Aussparung ist vorzugsweise wannenförmig flach ausgebildet und mit einer glasartigen Substanz gefüllt, die negative Ladungen aufweist.

Die glasartige Substanz kann aus einer ersten Teilschicht mit negativen Ladungen und aus wenigstens einer weiteren Teilschicht ohne solche Ladungen bestehen.

Die Flächenausdehnung des Bereichs grösserer Dicke der Kontaktzone kann gleich der Dicke der Planarzone oder kleiner als dieselbe sein.

Die Schichtenfolge kann zusätzlich eine in der Planarzone angeordnete hochdotierte äussere Zone vom einen Leitungstyp aufweisen, und die Flächenausdehnung des Bereichs grösserer Dicke der Kontaktzone ist dann vorzugsweise gleich der oder grösser als die Flächenausdehnung der äusseren Zone.

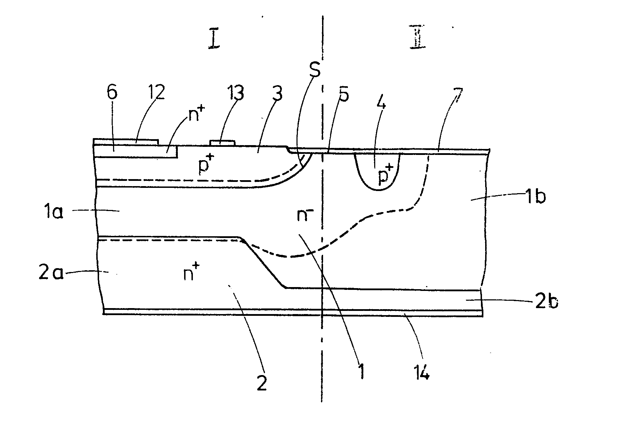

Anhand des in der Figur schematisch dargestellten Ausführungsbeispiels einer Transistorstruktur wird der Gegenstand der Erfindung aufgezeigt und erläutert.

Der Halbleiterkörper nach der Erfindung besteht aus einem Volumenabschnitt I mit einer Sperrspannung aufnehmenden Zonenfolge und aus einem Volumenabschnitt II mit Ausbildungen zur erwünschten Reduzierung der Oberflächenfeldstärke.

Im Volumenabschnitt I ist an einer Seite einer hochohmigen Mittelzone 1 aus n-leitendem Ausgangsmaterial ein vergleichsweise dicker Bereich 2a einer durchgehenden hochdotierten, die eine Hauptfläche des Halbleiterkörpers bildenden Kontaktzone gleichen Leitungstyps angeordnet.

An die andere Seite der Mittelzone 1 grenzt die mit dieser den Sperrspannung aufnehmenden pn-Übergang S bildende hochdotierte Planarzone 3 an. Die Konzentration der Mittelzone 1 kann beispielsweise $10^{13}$ pro cm³, diejenige des Abschnitts 2a der Kontaktzone $10^{20}$ pro cm³ und diejenige der Planarzone 3 $10^{18}$ bis $10^{20}$ pro cm³ betragen.

Die Planarzone 3 bildet bei einem Transistoraufbau die Basiszone und die Kontaktzone 2a bildet die Kollektorzone, während die Zone 6 als Emitterzone dient. Die Bemessung der Zonen 6 und 3 ist nicht erfindungswesentlich. Die Zone 1 ist in ihrem den äusseren Zonen 2a und 3 zugeordneten Bereich 1a so bemessen, dass bei vorgesehenen Sperrspannungen die Raumladungszone in die angrenzende Zone 2a eindringt. Durch deren hohe Störstellenkonzentration kann sich die Raumladungszone dort nur noch sehr wenig ausdehnen.

Die Bemessung der mittleren Zone 1 im Bereich 1a ist auch bestimmt durch dynamische Eigenschaften des Halbleiterbauelements sowie durch die Forderung nach möglichst geringem Durchlassspannungsabfall.

Die Bemessung des Bereichs 2a der Kontaktzone 2 ist unkritisch. Sie richtet sich einerseits nach der Forderung einer hohen mechanischen Stabilität des Schichtenaufbaus, insbesondere bei der Herstellung und bei der Verarbeitung, und kann z.B. das 10-fache bis 12-fache des anschliessenden Abschnitts 2b im Volumenabschnitt II betragen. Andererseits ist es erforderlich, den Weg für die im Bereich des pn-Übergangs entstehende Verlustwärme durch die Schichtenfolge zur Kollektoroberfläche möglichst kurz auszubilden. Dementsprechend kann die Dicke des Bereichs 2a auch z.B. lediglich nur das 4-fache der Dicke des Bereichs 2b betragen. Im Hinblick auf eine möglichst weite Spreizung der Raumladungszone in der Zone 1 des Volumenabschnitts II soll die Dicke des Bereichs 2a der Kontaktzone 2 wenigstens das 3-fache derjenigen des Bereichs 2b betragen.

Im Volumenabschnitt II ist die mittlere Zone 1 wesentlich erweitert ausgebildet und bildet im Anschluss an die Planarzone 3 die eine Hauptfläche des Halbleiterkörpers. Dieser Teil der Hauptfläche ist durch die Aussparung 5 abgesetzt gegenüber dem übrigen Flächenteil. Die Aussparung 5 dient zur Aufnahme einer passivierenden Substanz 7.

Sie ist wannenförmig flach ausgebildet und z.B. 2 bis 5 µm tief, und der unkritischen geringen Tiefe wegen ist nur ein geringer Ätzaufwand erforderlich. Gemäss einer bevorzugten Ausführung der Erfindung ist nun die Aussparung 5 mit einem negative Ladungen enthaltenden Glas, nachstehend Negativglas genannt, als passivierender Substanz 7 gefüllt. Die negativen Ladungen dieses Glases neutralisieren Minoritätsladungsträger in der Oberflächenschicht der n-leitenden Zone 1, welche andernfalls zu unerwünschten Oberflächenreaktionen mit der Wirkung einer Herabsetzung der kritischen Oberflächenfeldstärke der Anordnung beitragen können.

Die vorgesehenen Negativgläser entstehen durch Zugabe von bekannten Halbleiter-Dotierungsstoffen in Form einer Sauerstoffverbindung zu glasbildenden Substanzen. So sind Silicatgläser mit einem Zusatz einer Borverbindung, sogenannte Borsilicatgläser, bekannt. Auch die Verwendung von Zink und Blei liefert gewünschte Negativgläser. Dieselben sind jedoch bezüglich ihrer Herstellung und Zusammensetzung nicht Gegenstand der Erfindung. Vorteilhaft ist in der Aussparung 5 zunächst eine erste Teilschicht aus einem Negativglas und darüber wenigstens eine Teilschicht aus einem Glas ohne Ladungen angeordnet.

Diese Oberflächenpassivierung in Verbindung mit der Anordnung der Feldbegrenzungszone 4 und dem Verlauf der Planarzone 3 ermöglicht bei geringstem Verlust an aktiver Fläche eine Sperrspannungsbelastbarkeit, wie sie üblicherweise nur mit Kegelstumpfstrukturen erreichbar ist. Die Aussparung 5 verläuft vorteilhaft bis zur Mantelfläche des Halbleiterkörpers. Sie wird vorzugsweise bereits bei der Herstellung des Halbleiterkörpers aus einer grossflächigen Ausgangsscheibe jeweils in einer sich in zwei benachbarte Halbleiterkörper erstreckenden Flächenausdehnung gebildet und mit einer passivierenden Substanz versehen. Dadurch ist dann in günstiger Weise das Trennen der Ausgangsscheibe zwischen zwei vorgesehenen Halbleiterkörpern ohne unerwünschte Beeinträchtigung der physikalischen Eigenschaften der letzteren möglich.

Die eine Hauptfläche des Volumenabschnitts II enthält die im Abstand die Planarzone 3 umschliessende Feldbegrenzungszone 4. Deren Tiefe entspricht beispielsweise der Tiefe der Planarzone 3. Ihre Breite ist unkritisch, soll möglichst gering sein und ist nur durch fertigungstechnische Gesichtspunkte bestimmt. Der Abstand der Zone 4 zum pn-Übergang S richtet sich nach der Weite des Bereichs 1a der Mittelzone 1.

Weiter grenzt der Bereich 1b der Mittelzone 1 an den schmalen Bereich 2b der durchgehenden Kontaktzone 2. Auf derselben ist die Kontaktelektrode 14 aufgebracht, die Emitterzone 6 trägt die Kontaktelektrode 12 und die Basiszone 3 die Kontaktelektrode 13.

Der im wesentlichen stufenförmige Übergang zwischen den beiden Abschnitten 2a und 2b der Kontaktzone 2 liegt erfindungsgemäss innerhalb des durch die Projektion der Planarzone 3 auf die Schichtenebene gebildeten Volumenbereichs. Vorzugsweise ist die Flächenausdehnung des Kontaktzonenbereichs 2a kleiner als diejenige der Planarzone 3 und grösser als diejenige der Emitterzone 6.

Die in dem Bereich 2a der Kontaktzone 2 zusammengedrängte Raumladungsschicht erweitert sich beim Übergang in den Bereich 1b der Mittelzone 1, wodurch ausserhalb der $p^+n^-n^+$-Zonenfolge entsprechend dem Verlauf des pn-Übergangs eine grössere Spreizung der Raumladungsschicht besteht, die vor der Feldbegrenzungszone 4 durch dieselbe noch mehr erweitert wird. Damit ist eine optimale Reduzierung der Oberflächenfeldstärke erreicht. In einem Ausführungsbeispiel, bei dem die Mittelzone 1 im Volumenabschnitt I etwa 45 µm, der Bereich 2a der Kontaktzone 2 ca. 90 µm, die Planarzone 3 ca. 30 µm, die Aussparung 5 innerhalb der Planarzone 3 ca. 50 µm und ausserhalb ca. 300 µm betrugen, wurden Sperrspannungen etwa vom 3-fachen der bei herkömmlichen Planarstrukturen möglichen Werte erzielt.

Bei der Herstellung eines Halbleiterbauelements nach der Erfindung wird z.B. ein hochohmiges, n-leitendes Siliziumsubstrat mittels Diffusion auf einer Seite mit einer durchgehenden, hochdotierten Zone und auf der anderen Seite mithilfe der Maskentechnik in einem vorgegebenen Flächenbereich ebenfalls mit einer hochdotierten Zone jeweils vom gleichen Leitfähigkeitstyp des Ausgangsmaterials versehen. Anschliessend wird die durchgehende, hochdotierte Zone vollständig abgetragen, und auf dieser Seite werden gegenüber der hochdotierten $n^+$-Zone 2a die hochdotierte Planarzone 3 und im Abstand zu derselben die Feldbegrenzungszone 4, jeweils vom anderen Leitfähigkeitstyp, erzeugt. Die Flächenausdehnung der Planarzone 3 entspricht im wesentlichen derjenigen der Zone 2a. Damit liegt ein Halbleiterkörper vor, der aus einem Volumenabschnitt mit einer $p^+n^-n^+$-Zonenfolge und aus einem weiteren Volumenabschnitt mit einer, denselben vollständig durchsetzenden, hochohmigen n-leitenden Zone besteht. Danach wird mithilfe der Maskentechnik in die p-leitende Zone 3 die hochdotierte Emitterzone 6 vom Leitungstyp des Ausgangsmaterials und in die gesamte Fläche der anderen Seite des Halbleiterkörpers Störstellenmaterial hoher Konzentration ebenfalls vom Leitungstyp des Ausgangsmaterials eindiffundiert, wodurch eine Struktur gemäss der Darstellung entsteht. Weiter wird mit Hilfe der Maskentechnik durch Ätzen die Aussparung 5 erzeugt und mit einer Schicht eines Negativglases gefüllt, und abschliessend werden die Kontaktelektroden aufgebracht.

Die Vorteile der Erfindung bestehen darin, dass unter Anwendung einfacher Verfahrensschritte Halbleiterbauelemente aller Leistungsbereiche unter günstigster Flächennutzung mit erheblich höherer und gewünschter Sperrfähigkeit bei gleichbleibend guten anderen physikalischen Eigenschaften herstellbar sind.

## Patentansprüche

1. Halbleiterbauelement hoher Sperrfähigkeit, dessen Halbleiterkörper eine hochohmige Mittelzone (1) des einen Leitungstyps, eine an die Mittelzone (1) angrenzende, die eine Hauptfläche bildende, höher dotierte Kontaktzone (2) gleichen Leitungstyps und eine mit der Mittelzone (1) die andere Hauptfläche bildende, höher dotierte Planarzone (3) des anderen Leitungstyps sowie wenigstens eine, die Planarzone im Abstand umschliessende Feldbegrenzungszone (4) vom anderen Leitungstyp aufweist und mit entsprechenden Kontaktelektroden versehen ist, dadurch gekennzeichnet, dass in einem ersten Volumenabschnitt (I) des Halbleiterkörpers an die Mittelzone (1) ein Bereich (2a) der Kontaktzone (2) angrenzt, der dicker ausgebildet ist als der übrige Bereich (2b) der Kontaktzone, dass die Flächenausdehnung des Bereichs grösserer Dicke (2a) gleich derjenigen oder kleiner als diejenige der Planarzone (3) ist, dass in einem zweiten Volumenabschnitt (II) in der anderen Hauptfläche des Halbleiterkörpers eine Aussparung (5) angebracht ist, in welche der zwischen Mittelzone (1) und Planarzone (3) bestehende pn-Übergang (S) mündet, und welche sich bis über die Feldbegrenzungszone (4) hinaus erstreckt, dass die Aussparung (5) mit einer passivierenden Substanz (7) gefüllt ist, und dass die Mittelzone (1) im Bereich (2a) der Kontaktzone (2) mit grösserer Dicke eine solche Weite aufweist, dass sich die Raumladungsschicht im Betrieb des Halbleiterbauelements bis in die Kontaktzone (2) ausdehnt.

2. Halbleiterbauelement nach Anspruch 1, dadurch gekennzeichnet, dass die Dicke des Bereichs (2a) der Kontaktzone (2) wenigstens das Dreifache der Dicke des übrigen Bereichs (2b) beträgt.

3. Halbleiterbauelement nach Anspruch 1 oder 2, dadurch gekennzeichnet, dass die Aussparung (5) wannenförmig flach ausgebildet und mit einer glasartigen Substanz (7) gefüllt ist.

4. Halbleiterbauelement nach Anspruch 3, dadurch gekennzeichnet, dass die glasartige Substanz negative Ladungen aufweist.

5. Halbleiterbauelement nach Anspruch 4, dadurch gekennzeichnet, dass die glasartige Substanz aus einer ersten Teilschicht mit negativen Ladungen und aus wenigstens einer weiteren Teilschicht ohne negative Ladungen besteht.

6. Halbleiterbauelement nach einem der Ansprüche 1 bis 5, dadurch gekennzeichnet, dass in der Planarzone (3) eine hochdotierte äussere Zone (6) vom einen Leitungstyp angeordnet ist, und dass die Flächenausdehnung des Bereichs grösserer Dicke (2a) der Kontaktzone (2) gleich der oder grösser als die Flächenausdehnung der äusseren Zone (6) ist.

## Claims

1. Semiconductor device of high blocking capacity whose semiconductor body comprises a high resistance centre zone (1) of the one conductivity type, a higher doped contact zone (2) of the same conductivity type adjoining the centre zone (1) and forming a major face and a higher doped planar zone (3) of the other conductivity type forming with the centre zone (1) the other major face, and at least one field defining zone (4) of the other conductivity type surrounding the planar zone in spaced relationship, and being provided with corresponding contact electrodes, characterized in that in a first volume portion (I) of the semiconductor body the centre zone (1) is adjoined by a region (2a) of the contact zone (2) which is made thicker than the remaining region (2b) of the contact zone, that the area extent of the region of greater thickness (2a) is equal to or less than that of the planar zone (3), that in a second volume portion (2) in the other major face of the semiconductor body a recess (5) is formed into which the pn junction (S) existing between the centre zone (1) and the planar zone (3) opens and which extends beyond the field limiting zone (4), that the recess (5) is filled with a passivating substance (7) and that the centre zone (1) in the region (2a) of the contact zone (2) of greater thickness has a width such that the space charge layer in operation of the semiconductor device spreads into the contact zone (2).

2. Semiconductor device according to claim 1, characterized in that the thickness of the region (2a) of the contact zone (2) is at least three times the thickness of the remaining region (2b).

3. Semiconductor device according to claim 1 or 2, characterized in that the recess (5) is made shallow-trough-formed and filled with a vitreous substance (7).

4. Semiconductor device according to claim 3, characterized in that the vitreous substance comprises negative charges.

5. Semiconductor device according to claim 4, characterized in that the vitreous substance consists of a first sublayer with negative charges and at least one further sublayer without negative charges.

6. Semiconductor device according to any one of claims 1 to 5, characterized in that in the planar zone (3) a highly doped outer zone (6) of the one conductivity type is disposed, and that the area extent of the region of greater thickness (2a) of the contact zone (2) is equal to or greater than the area extent of the outer zone (6).

**Revendications**

1. Elément semi-conducteur à haute capacité de blocage, dont le corps semi-conducteur comporte une zone médiane (1) de valeur ohmique élevée d'un des types de conductivité, une zone de contact (2) du même type de conductivité, davantage dopée, adjacente à la zone médiane, constituant l'une des faces principales, une zone planaire (3), d'avantage dopée, du second type de conductivité, constituant ensemble avec la zone médiane l'autre face principale, au moins une zone de limitation du champ (4), du second type de conductivité, disposée à une certaine distance autour de la zone planaire, et, des électrodes de contact correspondantes, caractérisé en ce que: dans un premier segment de volume (I) du corps semi-conducteur, une partie (2a) de la zone de contact (2), plus épaisse que la partie restante (2b) de ladite zone, est adjacente à la zone médiane (1), la superficie de la partie (2a) plus épaisse est égale ou plus petite que la superficie de la zone planaire (3), dans un second segment de volume (II) du corps semi-conducteur, un évidement (5) est ménagé dans l'autre face principale dudit corps semi-conducteur, dans lequel débouche la jonction pn (S) existant entre la zone médiane (1) et la zone planaire (3), qui s'étend au-delà de la zone de limitation du champ (4) et qui est rempli d'une substance passivante (7), la largeur de la zone médiane (1) dans la partie (2a) plus épaisse de la zone de contact est telle que la zone de charge d'espace puisse s'étendre jusque dans la zone de contact (2) lorsque l'élément semi-conducteur est en état de fonctionnement.

2. Elément semi-conducteur selon la revendication 1, caractérisé en ce que l'épaisseur de la partie (2a) de la zone de contact (2) est au moins trois fois celle de la partie restante (2b).

3. Elément semi-conducteur selon l'une des revendications 1 et 2 caractérisé en ce que l'évidement (5) possède une forme de cuve plate et est rempli d'une substance vitreuse.

4. Elément semi-conducteur selon la revendication 3 caractérisé en ce que la substance vitreuse contient des charges négatives.

5. Elément semi-conducteur selon la revendication 4 caractérisé en ce que la substance vitreuse se compose d'une première couche contenant des charges négatives et d'au moins une seconde couche supplémentaire sans charges négatives.

6. Elément semi-conducteur selon l'une des revendications 1 à 5 caractérisé en ce que dans la zone planaire (3) est disposée une zone extérieure (6) hautement dopée d'un type de conductivité et en ce que la superficie de la partie plus épaisse (2a) de la zone de contact (2) est égale ou plus grande que la superficie de la zone extérieure (6).